# EUROPEAN PATENT APPLICATION

(11) **EP 4 002 447 A1**
(43) Date of publication of application: **25.05.2022**
(21) Application number: 20208397.8
(22) Date of filing: 18.11.2020
(51) Int. Cl.: H01L 23/492, H01L 23/495

(54) **CONTACT CLIP FOR SEMICONDUCTOR DEVICE PACKAGE**

(71) Applicant: Infineon Technologies Austria AG, 9500 Villach (AT)
(72) Inventor: DARYL YEOW, Yee Beng, 75350 Melaka (MY); HIEW, Mei Fen, 76450 Melaka (MY); WANG, Lee Shuang, 75450 Melaka (MY)
(74) Representative: Lambsdorff & Lange Patentanwälte Partnerschaft mbB

(57) **Abstract**

A contact clip (200, 400) for a semiconductor device package includes a first section configured to be mounted to a bond pad (122, 124) on a die (120). The contact clip further includes a second section configured to be mounted to a terminal post of a semiconductor device package. An intermediate section of the contact clip extends between the first section and the second section in a first lateral direction. The first section (220) is bent downwards from the intermediate section and has a dimension in the first lateral direction which narrows in the downward direction to end in a contact area surface (222) of a reduced first lateral dimension.

## Description

### Technical Field

This disclosure relates generally to the field of device packaging, and in particular to the technique of attaching a contact clip to a die.

### Background

Packaging a die in a semiconductor device usually includes connecting electrical terminals to the die. Wire bonding, ribbon bonding and clip bonding are viable options for die bonding. Wire bonding and clip bonding are sometimes combined in one package so as to benefit from the distinguishing characteristics of these techniques. While clip bonding allows for low electrical and thermal resistance, wire bonding is easy to automate and inexpensive in manufacture.

Clip bonding requires the contact clip to be precisely placed on the die and aligned with the contacts to be connected. Clip dislocation, misalignment and/or low quality solder joints between the clip and the contacts may impact the performance of the device or may result in scrap parts.

In particular, lateral transistor dies such as, e.g., III-V semiconductor power transistor dies feature long, narrow and small bond pad openings on the die. Manufacturing high quality electrical connections between long, narrow and small bond pad openings and a clip can be challenging in practice.

### Summary

According to an aspect of the disclosure, a contact clip for a semiconductor device package comprises a first section configured to be mounted to a bond pad on a die and a second section configured to be mounted to a terminal post of a semiconductor device package. The contact clip further comprises an intermediate section extending between the first section and the second section in a first lateral direction. The first section is bent downwards from the intermediate section and has a dimension in the first lateral direction which narrows in the downward direction to end in a contact area surface of a reduced first lateral dimension.

According to another aspect of the disclosure, a semiconductor device package comprises a die carrier and a die mounted on the die carrier. The semiconductor device package further comprises at least one contact clip as described above that is mounted to a bond pad on the die and to a terminal post of the semiconductor device package.

According to still another aspect of the disclosure, a method of manufacturing a contact clip comprises narrowing the thickness of an end portion of a metal sheet to end in a contact area surface of a reduced thickness. A part of the metal sheet is bent down to form a bent down first section of the contact clip configured to be mounted to a bond pad at the contact area surface.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1 is a schematic top view on an exemplary semiconductor device package including a die mounted on a carrier and a contact clip contacting the die.
Figure 2 is a schematic cross-sectional view of the exemplary semiconductor device package of Figure 1 along line A-A and further illustrates an enlarged detail of the view.
Figure 3A is a schematic cross-sectional view of an exemplary contact clip having a curved side wall end portion.
Figure 3B is a schematic cross-sectional view of an exemplary contact clip having a stepped side wall end portion.
Figure 4A is a perspective side view of sub-sections of the first section of an exemplary contact clip having a plurality of curved side wall end portions.
Figure 4B is a perspective bottom view of the sub-sections of the first section of the exemplary contact clip of Figure 4A.
Figure 4C is a side view of the end portion of the first section of the exemplary contact clip of Figures 4A-4B.
Figure 4D is a top view of the exemplary contact clip of Figures 4A-4C.
Figure 5 is a side view of an end portion of the first section of an exemplary contact clip having a stepped side wall end portion and a curved side wall end portion opposite the stepped side wall end portion.
Figure 6 is a schematic cross-sectional view of an exemplary contact clip having a solder deposit pre-attached to a contact area surface of the contact clip.
Figure 7 is a flowchart illustrating exemplary stages of a method of manufacturing a contact clip.
Figures 8A-8C illustrate an exemplary stage of narrowing end portions of a metal sheet, an exemplary stage of coating the side faces of the metal sheet and an exemplary stage of bending the processed metal sheet for manufacturing a contact clip.

### Detailed description

It is to be understood that the features of the various exemplary embodiments and examples described herein may be combined with each other unless specifically noted otherwise.

As used in this specification, the terms "electrically connected" or "connected" or similar terms are not meant to mean that the elements are directly contacted together; intervening elements may be provided between the "electrically connected" or "connected" elements, respectively. However, in accordance with the disclosure, the above-mentioned and similar terms may, optionally, also have the specific meaning that the elements are directly contacted together, i.e. that no intervening elements are provided between the "electrically connected" or "connected" elements, respectively.

Further, the words "over" or "beneath" with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

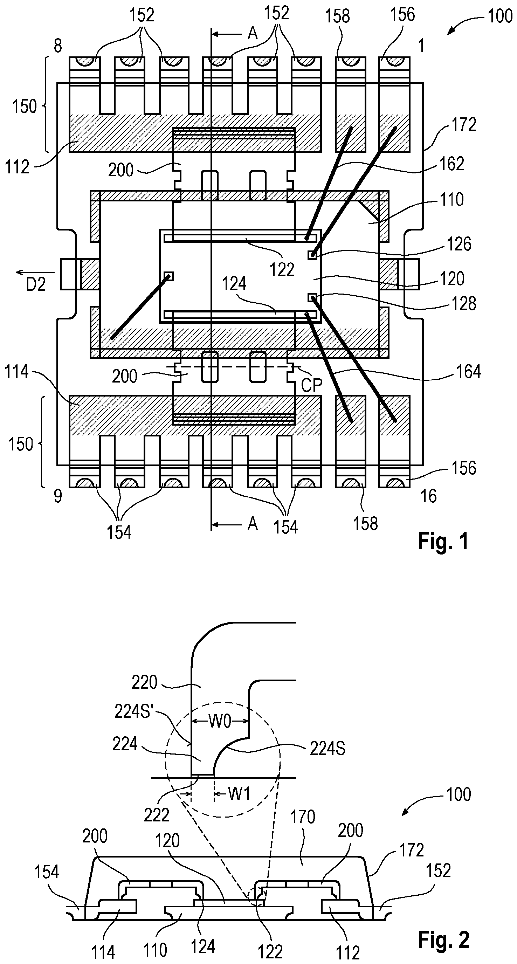

Figure 1 illustrates an exemplary semiconductor device package 100. The semiconductor device package 100 may include a die carrier 110 and a die 120 mounted on the die carrier 110. The semiconductor device package 100 further includes at least one contact clip 200. By way of example, in Figures 1 and 2 two contact clips 200 are implemented.

The contact clip 200 is mounted to a bond pad 122 or 124 on the die 120 and to a terminal post 112 or 114, respectively, of the semiconductor device package 100. Throughout the description mounting can, e.g., be carried out by solder mounting using solder as a bonding material or by using other mounting techniques such as, e.g., techniques using a conductive adhesive or a sinter material as a bonding material.

The die carrier 110 may be a heat sink element, e.g., a bulk metal plate. The die carrier 110 may, e.g., be a part of a (metallic) leadframe, i.e. be the die pad of the leadframe. The die carrier 110 may be made of or comprise any metal or metal alloy, e.g. copper or copper alloy. In other embodiments the die carrier 110 may be a PCB (printed circuit board) or a metal bonded ceramic substrate, e.g. a DCB (direct copper bonded) ceramic substrate.

The semiconductor device package 100 may further comprise external terminals 150. For instance, the external terminals 150 may include first load terminals 152, second load terminals 154, one or more control terminals 156 and one or more sense terminals 158.

The external terminals 150 are connected to bond pads on the die 120. For instance, as shown in Figures 1 and 2, one contact clip 200 is configured to electrically connect the bond pad 122 to the terminal post 112 of the first load terminals 152, and the other contact clip 200 is configured to electrically connect the bond pad 124 of the die 120 to the terminal post 114 of the second load terminals 154. Further, as illustrated in Figure 1, the bond pad 122 may be electrically connected by, e.g., a bond wire 162 to a sense terminal 158 (e.g. source1 sense) of the semiconductor device package 100 and/or the bond pad 124 may be electrically connected by, e.g., a bond wire 164 to the other sense terminal 158 (e.g. source2 sense) of the semiconductor device package 100. Further, one or more control pads 126, 128 (e.g. gate1 bond pad opening and gate2 bond pad opening of a bi-directional switch) may be electrically connected to one or more of the control terminals 156 of the semiconductor device package 100. For instance, the load terminals 152, 154 are source and drain terminals (or source1 and source2 terminals of a bi-directional switch) and the control terminal(s) 156 is (are) gate terminal(s) (e.g. gate1 and gate2 terminals of a bi-directional switch) of the semiconductor device package 100.

The external terminals 150 may be leads of a leadframe. In this case, the die carrier 110 may form the die pad of the leadframe. However, the semiconductor device package 100 may also be realized as a leadless package, i.e. a package having external terminals which are not implemented by leads. In this case, the external terminals 150 may be implemented by bottom electrodes of the semiconductor package 100. Such bottom electrodes may, e.g., not protrude out of a lateral periphery 172 of a package body 170 of the semiconductor device package 100 and/or may be shaped as short pins which protrude out of the lateral periphery 172 of the package body 170 only by a small distance (see Figures 1 and 2).

The semiconductor device package 100 may be a package optimized for high current applications having a current capacity of, e.g., equal to or greater than 100 A or 200 A or 300 A or 400 A. For instance, embodiments of this description may be applied to a known transistor package of Infineon^{®} known as TOLL (transistor outline leadless) package which has a similar general shape and construction as the example shown in Figures 1 and 2.

The package body 170 may, e.g., be made of a mold compound or another type of encapsulant. The die 120 and the contact clip(s) 200 may be completely encapsulated by the package body 170. The die carrier 110 may, e.g., be completely encapsulated by the package body 170 or may, e.g., be partly exposed at a bottom surface of the package body 170.

The die 120 may monolithically integrate one or more transistors and/or diodes, e.g. one or more power transistors and/or power diodes.

For instance, the die 120 may be configured as including one or more MISFETs (Metal Insulator Semiconductor Field Effect Transistors), MOSFETs (Metal Oxide Semiconductor Field Effect Transistors), IGBTs (Insulated Gate Bipolar Transistors), JFETs (Junction Gate Field Effect Transistors), HEMTs (High Electron Mobility Transistors), bipolar transistors or diodes such as, e.g., PIN diodes or Schottky diodes.

In particular, the die 120 may include a lateral power transistor. As shown in Figures 1 and 2, in a lateral power transistor, the control pad(s) 126, 128, the first load pad 122 and the second load pad 124 of the die 120 are usually disposed on the top surface of the die 120.

In particular, the lateral power transistor implemented in the die 120 may be a III-V hetero-structure transistor such as, e.g., a GaAs, InP, GaP or GaN hetero-structure transistor, e.g. a HEMT comprising a two-dimensional electron gas (2DEG). Such transistors provide for a high power density and a high efficiency at high switching frequencies. For instance, when compared to silicon, GaN allows higher operation frequency with higher power density and lower power losses.

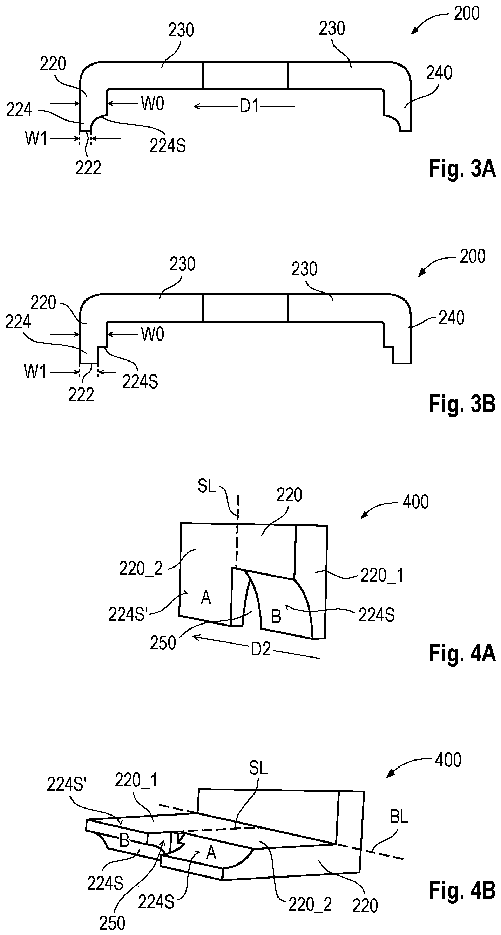

Figure 3A in conjunction with the enlarged portion of Figure 2 illustrate an exemplary embodiment of the contact clip 200. The contact clip 200 includes a first section 220 configured to be mountable to a bond pad 122 or 124 on the die 120. For example, the first section 220 may be configured such that it is capable of being mounted (e.g. solder mounted) onto bond pad 122 or 124. The contact clip 200 further comprises a second section 240 configured to be mountable such as, e.g., by solder to a terminal post such as, e.g., terminal post 112 or terminal post 114 of the semiconductor device package 100. An intermediate section 230 of the contact clip 200 extends between the first section 220 and the second section 240 in a first lateral direction D1. The first lateral direction D1 may be in the sectional plane along line A-A of Figure 1. The first lateral direction D1 may, e.g., be substantially parallel to a surface of the die carrier 110 (see Figure 2).

The first section 220 is bent downwards from the intermediate section 230. The angle of inclination between the intermediate section 230 and the first section 220 may, e.g., be about 90°. Similarly, the second section 240 may be bent downwards from the intermediate section 230. That is, the first section 220 and/or the second section 240 may be generated by bending. However, in other examples, the second section 240 may be straight with the intermediate section 230.

The first section 220 has a dimension W in the first lateral direction D1 which narrows in the downward direction to end in a contact area surface 222 of a reduced first lateral dimension. In the following the first lateral dimension of the first section 220 of the contact clip 200 will be referred to as width W. That is, the first section 220 may have a width W0 in an upper portion of the first section and may have a reduced width W1 at the contact area surface 222 at which the first section 220 ends.

There are many different possibilities how to reduce the initial width W0 of the first section 220 to end in the reduced width W1 at the contact area surface 222. For instance, the first section 220 may narrow in the downward direction by providing an end portion 224 of the second section 240 having a narrowing side wall 224S. For instance, the narrowing side wall 224S may be a curved side wall as shown in Figure 3A.

The reduced width W1 may be equal to or smaller than 0.8 or 0.7 or 0.6 or 0.5 times the initial (i.e. not narrowed) width W0 of the first section 220. However, the contact area surface 222 of reduced width W1 may not be designed as a sharp tip. Rather, the contact area surface 222 may be planar, e.g. coplanar with the first direction D1. The reduced width W1 of the contact area surface 222 may be equal to or greater than 0.2 or 0.3 or 0.4 or 0.5 or 0.6 or 0.7 times the initial (i.e. not narrowed) width W0 of the first section 220. In other words, the contact area surface 222 of the contact clip 200 is scalable according to bond pad area size to cater smaller chip sizes with small and/or narrow bond pad openings.

A sharp tip is undesirable because it results in issues with cracked dies and inconsistent solder due to the pointed edge piercing through the solder. The dimensions of the "half-edge" contact area surface 222 being smaller than the full thickness (width W0) of the contact clip facilitates contact with smaller bond pad openings whilst avoiding the issues associated with having a sharp tip.

The vertical dimension of the end portion 224 of the first section 220, i.e. the distance from the beginning of the narrowing (e.g. curved) side wall 224S to its end at the contact area surface 222 may, e.g., be about equal to or smaller than the initial width W0.

Further, a side wall 224S' of the end portion 224 opposite the narrowing (e.g. curved) side wall 224S may have a straight shape. Differently put, the reduction of the width from W0 to W1 may be caused only by one of the side walls 224S, 224S' of the end portion 224 of the first section 220.

As illustrated in Figure 1, the contact clip 200 may have a substantial extension in a second lateral dimension D2, which is perpendicular to the first lateral direction D1. The second lateral dimension D2 will be referred to as length L in the following. The length L of the contact clip 200 is determined by the dimensions of the bond pad 122 the contact clip 200 is to be attached to. The contact clip 200 (or more specifically the first section 220 of the contact clip 200) can have a length L which may be of the same size or longer than the not narrowed first lateral dimension (width W0) of the first section 220. Hence, the contact clip 200 and, more specifically, the first section 220 of the contact clip 200 may have a length L which is equal to or greater than 2 or 5 or 10 or 15 or 20 or 30 or 40 times the not narrowed first lateral dimension (width W0) of the first section 220.

Each of the load current bond pads 122, 124 may be designed as a long, narrow continuous bond pad opening (BPO) that is rectangular in shape. For example, the dimensions may be 0.1 mm times 4 mm.

Conventional III-V hetero-structure devices are known to be provided with rows of small individual bond pad openings which are used for wire bonding. That is, a conventional interconnect for conventional bond pads 122 and/or 124 consists of a plurality of bond wires, wherein each bond wire is contacted to an individual bond pad opening (i.e. to an individual bond pad exposed by a bond pad opening) in the row of bond pads. Bond wires, however, are prone to wire sweep during molding and may have a risk of shorting.

The contact clip 200 as disclosed herein can overcome these shortcomings of conventional wire bonding and can provide for a better electrical connection between the die 120 and the external terminals 150, thereby lowering the R_{DS,ON} (drain-source-on-resistance) of the transistor. Further, the specific design of the first section 220 of the contact clip 200 improves the reliability and quality of the electrical and mechanical contact between the bond pad 122 or 124 and the contact clip 200.

For instance, the length of the bond pads 122 and/or 124, e.g. as defined by the bond pad opening size in direction D2, may be about 4 mm ±1 mm or ±2 mm or ±3 mm or ±3.9 mm. The width of the bond pads 122 and/or 124, e.g. as defined by the bond pad opening size in direction D1, may be about 0.2 mm or smaller, e.g. in a range between 0.2 mm and 0.1 mm.

The width W0 of the first section 220 of the contact clip may, e.g., be in a range between 0.1 mm and 0.25 mm and, more specifically, about 0.125 mm. The reduced width W1 at the contact area surface 222 may, e.g., be W0/2 or within the ranges in relation to W0 as defined above.

The size-reduced contact area surface 222 allows easier placement and alignment of the contact clip 200 on the die 120. The clearance required between the die pad opening (or die pad size) and the contact area surface 222 depends on factors such as the precision of placement for the contact clip 200 on the die 120. The size-reduced contact area surface 222 (i.e. with width W1) reduces the required precision in comparison with a contact area surface 222 of initial size (i.e. with width W0). Further, the narrowing side wall 224S of the end portion 224 of the first section 220 provides additional surface area at the contact clip 200 for the connection of the solder joint. Differently put, the narrowing side wall 224S provides space for the solder joint to better accommodate in the first lateral direction D1 to the size of the bond pad (that is, e.g., to the bond pad opening size) and provides additional surface area at the contact clip 200 for the solder joint by exploiting the vertical dimension. These effects improve both the mechanical and electrical properties of the solder joint.

In short, the contact clip design as described herein facilitates contact clip placement while simultaneously improving the electrical properties of the solder joint between the bond pad 122, 124 and the contact clip 200.

The second section 240 may have the same shape as the first section 220. More specifically, the contact clip 200 may be symmetric with respect to a center plane CP (see Figure 1) running along the second lateral direction D2. In this case, the contact clip 200 may be assembled irrespective of its orientation so that the process of contact clip placement is made easier.

In one example, the second section 240 may have a different shape than the first section 220. More specifically, the second section 240 may not be equipped with a narrowing side wall end portion. That is, the second section 240 may have a flat contact surface area of initial width W0 since this contact surface area lands on the terminal posts 112, 114, where usually enough place is available for proper contacting. In one example, except this difference between the end potions of the first section 220 and the second section 240, the contact clip 200 may still be symmetric with respect to the center plane CP.

The curved side wall 224S of the end portion 224 of the first section 220 and/or the second section 240 may be formed by etching. Etching may be carried out by covering all surface areas of the contact clip 200 with an etch mask except the edge or corner region to be etched away. The etching process then removes the uncovered edge or corner of the end portion 224 and produces the curved side wall 224S. In this case, the curved side wall 224S is a surface produced by etching. The curved side wall 224S may directly adjoin the contact area surface 222.

Figure 3B illustrates another example of a contact clip 200. The contact clip 200 of Figure 3B may be identical to the contact clip 200 of Figure 3A with the exception that the curved narrowing side wall 224S of Figure 3A is replaced by a stepped narrowing side wall 224S of the end portion 224 of the first section 220. In view of other features of the contact clip 200 of Figure 3B, reference is made to the above description for the sake of brevity.

The stepped side wall 224S may, e.g., be generated by mechanical machining, e.g. by a stamping, coining or cutting process. In this case, the stepped side wall 224S is a surface produced by mechanical treatment.

It is to be noted that the intermediate section 230 may have the same width W0 as the first section 220 and/or the second section 240.

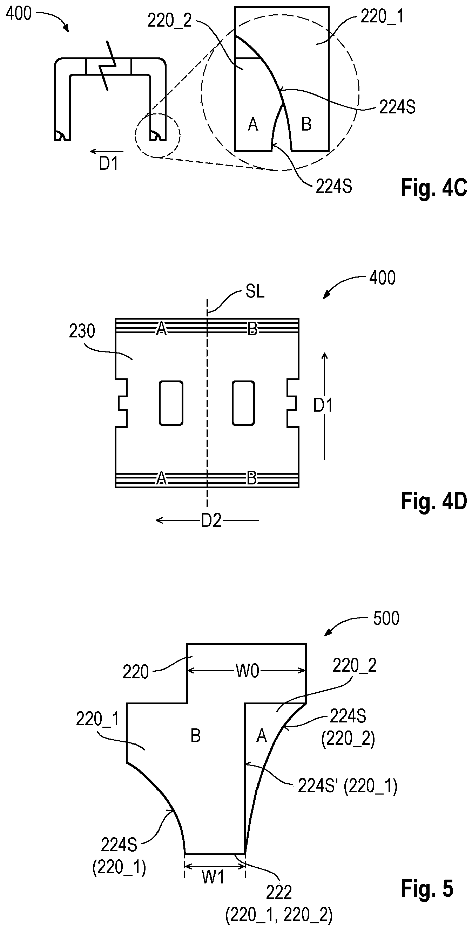

Figures 4A-4D illustrate an example of a contact clip 400 having a plurality of curved side wall end portions. More specifically, the first section 220 comprises a first sub-section 220_1 and a second sub-section 220_2. The first sub-section 220_1 and the second sub-section 220_2 are disposed adjacent to each other in the second lateral direction D2 (e.g. the subdivision line SL may indicate the boundary between the first and second sub-sections 220_1, 220_2). An end portion of the first sub-section 220_1 is denoted by "B" and an end portion of the second sub-section 220_2 is denoted by "A". An outer side wall of the first sub-section 220_1 has a narrowing, e.g. curved (as shown) or stepped (not shown) side wall end portion 224S at end portion B, and an inner side wall of the second sub-section 220_2 has a narrowing, e.g. curved (as shown) or stepped (not shown) side wall end portion 224S at end portion A. A bending line along which the first section 220 has been bent down from the intermediate section 230 is denoted by BL in Figure 4B.

Further, an inner side wall end portion 224S' of the first sub-section 220_1 opposite the curved or stepped side wall end portion 224S has a straight shape (at end portion B) and an outer side wall end portion 224S' of the second sub-section 220_2 opposite the curved or stepped side wall end portion 224S has a straight shape (at end portion A).

As apparent from Figure 4B, the first section 220_1 is optionally provided with a cutout 250 disposed between the end portion B of the first sub-section 220_1 and the end portion A of the second sub-section 220_2.

While the exemplary contact clip 400 is equipped with two sub-sections 220_1, 220_2 of the first section 220 of the contact clip 400 arranged along the second lateral direction D2, the contact clip 400 may also be equipped with more than two (e.g. with 3, 4, 5, 6, ...) such sub-sections 220_1, 220_2, ....

The sub-division of the first section 220 of the contact clip 400, as illustrated in Figures 4A-4D, helps to avoid floating of the contact clip 400 during reflow and stabilizes the assembly by providing narrowing (e.g. curved or stepped) side walls 224S on both sides of the first section 220, see Figure 4D. Further, the partial etched/stamped contact clip design as shown in Figures 4A-4D allows better solder coverage to target smaller bond pad openings on the die.

Figure 5 illustrates the first section 220 of an exemplary contact clip 500. The first section 220 is again subdivided in a plurality of sub-sections 220_1, 220_2. The end portion B of sub-section 220_1 of the contact clip 500 may comprise a curved side wall end portion 224S and a stepped side wall end portion 224S' opposite the curved side wall end portion 224S. This end portion design may be fabricated by applying an etching process to form the curved side wall end portion 224S and by applying a stamping or coining process to form the stepped side wall end portion 224S'.

By way of example, if this process is carried out to reshape the end portion B of the first sub-section 220_1 of the contact clip 400, the contact area surface 222 of the first sub-section 220_1 is aligned with the contact area surface 222 of the second sub-section 220_2. By way of example, in Figure 5, e.g. W0 = 0.1 mm and W1 = 0.05 mm and the stamping process to relocate the contact area surface 222 of the first sub-section 220_1 comprises a 0.05 mm displacement for contact area surfaces 222 alignment.

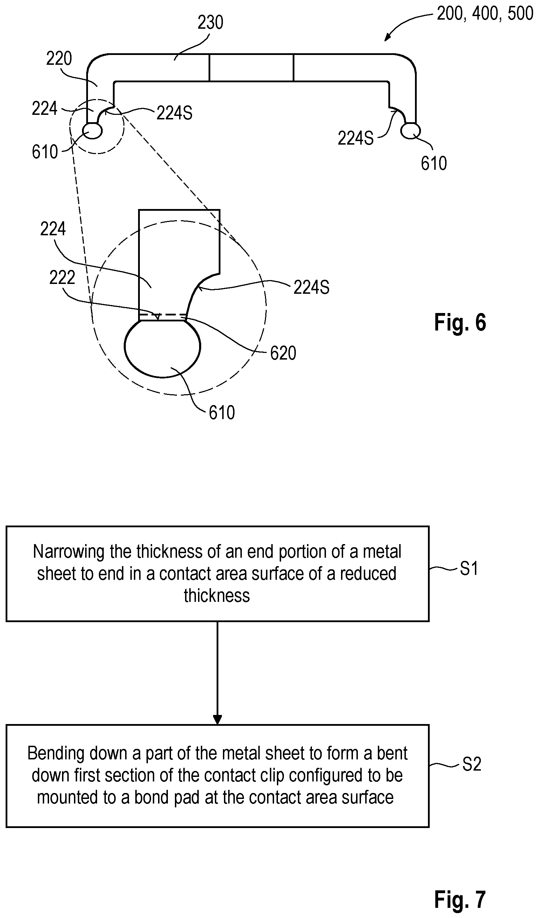

Referring to Figure 6, a solder deposit 610 may be pre-attached to the flat contact area surface 222 before the contact clip 200, 400, 500 is mounted. The solder deposit pre-attach may be helpful during reflow for the contact clip attach process. During reflow the solder deposit 610 melts and both the contact area surface 222 and the narrowing (e.g. curved or stepped) side wall end portion 224S will be wetted and covered by the solder. That is, the side wall end portion 224S provides additional surface area for the solder joint by exploiting the vertical dimension.

With the solder deposit pre-attach, no additional solder may be required for reflow. This means that the conventional step of dispensing solder onto the bond pads 122, 124 and/or onto the terminal posts 112, 114 can be eliminated. Without this solder deposit pre-attach as disclosed herein, the dispense of solder is a required additional manufacturing step.

As shown in Figure 6 the contact area surface 222 may optionally be provided by a metal coating layer 620 disposed at the end of the end portion 224. The metal of the metal coating layer 620 is different from the metal of the contact clip 200, 400, 500. For instance, the metal coating layer 620 may comprise or be of Au.

Referring to Figure 7, at S1 the thickness of an end portion of a metal sheet is narrowed to end in a contact area surface of a reduced thickness. The metal sheet may, e.g., be of copper or a copper alloy. The thickness of the metal sheet may, e.g., be W0. The metal sheet forms the raw material of the contact clip. The metal sheet may be a metal part structured by etching or stamping, e.g. a leadframe.

At S2 a part of the metal sheet is bent down to form a bent down first section of the contact clip configured to be mounted to a bond pad at the contact area surface. The part of the metal sheet may be bent down along a bending line extending in the second lateral direction. That way, a first lateral dimension of an end portion of the first section is narrowed to end in a reduced first lateral dimension of the contact area surface. The first lateral dimension extends in the first lateral direction which is perpendicular to the second lateral direction.

The process of narrowing the first lateral dimension W0 to the reduced first lateral dimension W1 of the contact area surface may, e.g., be carried out by etching or mechanical machining, e.g. stamping, coining or cutting. It may be carried out before or after the bending process.

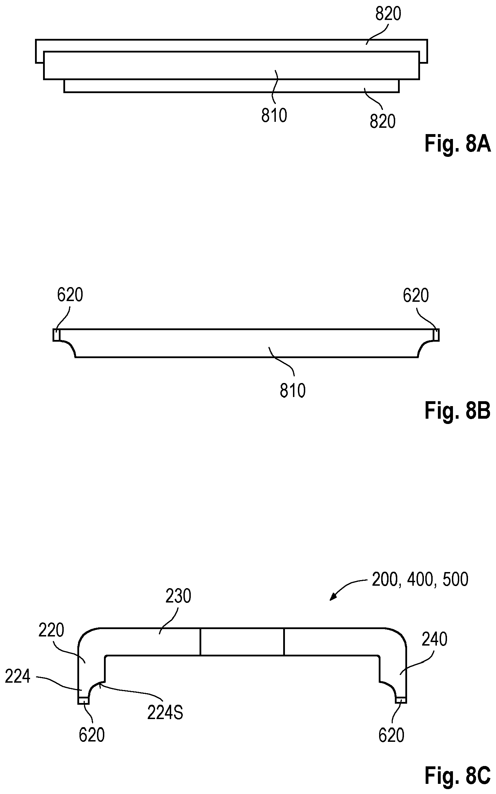

Referring to Figure 8A, the main surfaces and the side surfaces of a metal sheet 810 such as, e.g., a leadframe may be covered by an etch mask 820. The etch mask 820 may, e.g., be made of silicone or any other material resistive to etching.

The etch mask 820 may then be partially removed in the vicinity of the lower side face edges of the metal sheet 810. More specifically, a part of the side face(s) of the metal sheet 810 may remain covered by the etch mask 820, while another part adjoining the lower side face edge may be exposed. Further, a part of the lower main surface adjoining the lower side face edge may be exposed.

The metal sheet 810 is then etched to produce the curved side wall end portions 224. This forms the "half-etch" contact area design. The etch mask 820 may then be stripped.

Optionally, the metal sheet 810 may then be coated at its side faces with the metal coating layer 620, see Figure 8B. The metal coating layer 620 may be applied by metal plating (e.g. Au plating).

The metal sheet 810 is then bent in shape as illustrated in Figure 8C.

### EXAMPLES

The following examples pertain to further aspects of the disclosure:
Example 1 is a contact clip for a semiconductor device package, the contact clip comprising a first section configured to be mounted to a bond pad on a die; a second section configured to be mounted to a terminal post of a semiconductor device package; and an intermediate section extending between the first section and the second section in a first lateral direction; wherein the first section is bent downwards from the intermediate section and has a dimension in the first lateral direction which narrows in the downward direction to end in a contact area surface of a reduced first lateral dimension.
In Example 2, the subject matter of Example 1 can optionally include wherein the first section narrows in the downward direction by having a curved side wall end portion or a stepped side wall end portion.
In Example 3, the subject matter of Example 1 or 2 can optionally include wherein a side wall end portion of the first section opposite the curved or stepped side wall end portion has a straight shape.
In Example 4, the subject matter of any preceding Example can optionally include wherein the reduced first lateral dimension is equal to or smaller than 0.8 or 0.7 or 0.6 or 0.5 times the not narrowed first lateral dimension of the first section.
In Example 5, the subject matter of any preceding Example can optionally include wherein the first section comprises a first sub-section and a second sub-section, the first sub-section and the second sub-section are disposed adjacent to each other in a second lateral direction which is perpendicular to the first lateral direction, wherein an outer side wall of the first sub-section has a curved or stepped side wall end portion, and an inner side wall of the second sub-section has a curved or stepped side wall end portion.
In Example 6, the subject matter of Example 5 can optionally include wherein an inner side wall end portion of the first sub-section opposite the curved or stepped side wall end portion has a straight shape, and an outer side wall end portion of the second sub-section opposite the curved or stepped side wall end portion has a straight shape.
In Example 7, the subject matter of Example 5 or 6 can optionally include wherein the first section has an end portion which is provided with a cutout disposed between an end portion of the first sub-section and an end portion of the second sub-section.
In Example 8, the subject matter of Example 2 can optionally include wherein a side wall of the first section has a curved side wall end portion and a side wall end portion opposite the curved side wall end portion has a stepped shape.
In Example 9, the subject matter of any preceding Example can optionally include wherein a solder deposit pre-attached to the contact area surface before the contact clip is mounted.
Example 10 is semiconductor device package comprising a die carrier; a die mounted on the die carrier; and at least one contact clip of one of the preceding Examples that is mounted to a bond pad on the die and to a terminal post of the semiconductor device package.
In Example 11, the subject matter of Example 10 can optionally include wherein the die comprises a lateral transistor having a first row of bond pad openings associated with a first load electrode of the lateral transistor and a second row of bond pad openings associated with a second load electrode of the lateral transistor, further comprising: at least two contact clips of one of the preceding Examples, wherein a first contact clip is mounted to the first row of bond pad openings and a second contact clip is mounted to the second row of bond pad openings.
In Example 12, the subject matter of Example 10 or 11 can optionally include wherein the die comprises a lateral high electron mobility transistor.
Example 13 is a method of manufacturing a contact clip, the method including narrowing the thickness of an end portion of a metal sheet to end in a contact area surface of a reduced thickness; and bending down a part of the metal sheet to form a bent down first section of the contact clip configured to be mounted to a bond pad at the contact area surface.
In Example 14, the subject matter of Example 13 can optionally include wherein narrowing is carried out by etching or stamping.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A contact clip for a semiconductor device package, the contact clip comprising:
a first section configured to be mounted to a bond pad on a die;
a second section configured to be mounted to a terminal post of a semiconductor device package; and
an intermediate section extending between the first section and the second section in a first lateral direction; wherein
the first section is bent downwards from the intermediate section and has a dimension in the first lateral direction which narrows in the downward direction to end in a contact area surface of a reduced first lateral dimension.

2. The contact clip of claim 1, wherein the first section narrows in the downward direction by having a curved side wall end portion or a stepped side wall end portion.

3. The contact clip of claim 2, wherein a side wall end portion of the first section opposite the curved or stepped side wall end portion has a straight shape.

4. The contact clip of one of the preceding claims, wherein the reduced first lateral dimension is equal to or smaller than 0.8 or 0.7 or 0.6 or 0.5 times the not narrowed first lateral dimension of the first section.

5. The contact clip of one of the preceding claims, wherein the first section comprises a first sub-section and a second sub-section, the first sub-section and the second sub-section are disposed adjacent to each other in a second lateral direction which is perpendicular to the first lateral direction, wherein
an outer side wall of the first sub-section has a curved or stepped side wall end portion, and
an inner side wall of the second sub-section has a curved or stepped side wall end portion.

6. The contact clip of claim 5, wherein
an inner side wall end portion of the first sub-section opposite the curved or stepped side wall end portion has a straight shape, and
an outer side wall end portion of the second sub-section opposite the curved or stepped side wall end portion has a straight shape.

7. The contact clip of claim 5 or 6, wherein the first section has an end portion which is provided with a cutout disposed between an end portion of the first sub-section and an end portion of the second sub-section.

8. The contact clip of claim 2, wherein a side wall of the first section has a curved side wall end portion and a side wall end portion opposite the curved side wall end portion has a stepped shape.

9. The contact clip of one of the preceding claims, further comprising:
a solder deposit pre-attached to the contact area surface before the contact clip is mounted.

10. A semiconductor device package, comprising:
a die carrier;
a die mounted on the die carrier; and
at least one contact clip of one of the preceding claims that is mounted to a bond pad on the die and to a terminal post of the semiconductor device package.

11. The semiconductor device package of claim 10, wherein the die comprises a lateral transistor having a first row of bond pad openings associated with a first load electrode of the lateral transistor and a second row of bond pad openings associated with a second load electrode of the lateral transistor, further comprising:
at least two contact clips of one of the preceding claims, wherein a first contact clip is mounted to the first row of bond pad openings and a second contact clip is mounted to the second row of bond pad openings.

12. The semiconductor device package of claim 10 or 11, wherein the die comprises a lateral high electron mobility transistor.

13. A method of manufacturing a contact clip, comprising:
narrowing the thickness of an end portion of a metal sheet to end in a contact area surface of a reduced thickness; and
bending down a part of the metal sheet to form a bent down first section of the contact clip configured to be mounted to a bond pad at the contact area surface.

14. The method of claim 13, wherein narrowing is carried out by etching or stamping.
